# DEMANDE DE BREVET EUROPEEN

(11) **EP 3 809 455 A1**
(43) Date de publication de la demande: **21.04.2021**
(21) Numéro de dépôt: 20200176.4
(22) Date de dépôt: 06.10.2020
(51) Int. Cl.: H01L 21/762, H01L 27/105, H01L 27/11541

(54) **PROCÉDÉ DE FABRICATION DE CIRCUIT INTÉGRÉ COMPRENANT UNE PHASE DE FORMATION DE TRANCHÉES DANS UN SUBSTRAT ET CIRCUIT INTÉGRÉ CORRESPONDANT**

(30) Priorité: 16.10.2019 FR 1911549
(71) Demandeur: STMicroelectronics (Rousset) SAS, 13790 Rousset (FR)
(72) Inventeur: JULIEN, Franck, 13821 LA PENNE SUR HUVEAUNE (FR); MARZAKI, Abderrezak, 13100 AIX EN PROVENCE (FR)
(74) Mandataire: Casalonga

(57) **Abrégé**

Le procédé de fabrication de circuit intégré comprend une phase de formation de tranchées comprenant :
- une formation d'une première couche d'arrêt (20) ;
- une formation d'une deuxième couche d'arrêt (30) sur la première couche d'arrêt (20) dans une deuxième zone (Z2) seulement ;
- une gravure sèche (400) configurée pour graver en un temps donné la première couche d'arrêt (20) puis au moins une première tranchée (410) dans le substrat (10) jusqu'à une première profondeur (P1), et pour graver en même temps dans la deuxième zone (Z2), la deuxième couche d'arrêt (30), puis la première couche d'arrêt (20), puis au moins une deuxième tranchée (420) dans le substrat (10) jusqu'à une deuxième profondeur (P2), la deuxième profondeur (P2) étant inférieure à la première profondeur (P1).

## Description

Des modes de mise en œuvre et de réalisation concernent les circuits intégrés, en particulier la formation de tranchées dans un substrat semiconducteur.

La formation de tranchées dans le substrat semiconducteur d'un circuit intégré est utilisée à de nombreux égards.

Par exemple, une phase de formation de tranchée est typiquement prévue pour la fabrication de régions d'isolation latérales (usuellement désignées par l'acronyme « STI » du terme anglais « Shallow Trench Isolation »). Les tranchées d'isolation latérale permettent d'isoler électriquement par exemple des transistors, pouvant être incorporés à une partie logique ou dans une région de mémoire non volatile.

Pour des raisons évidentes d'économie des coûts de fabrications, les tranchées d'isolation latérale situées dans la partie logique et dans la partie de mémoire non volatile sont réalisées simultanément et ont la même structure.

Cela étant, la partie logique comprend typiquement des implantations de dopants en quantité importante, qui engendrent des défauts cristallins pouvant provoquer des dislocations, si les contraintes mécaniques sont élevées. Le volume de diélectrique des tranchées d'isolation latérale peut engendrer de telles contraintes, et il serait souhaitable à cet égard de diminuer le volume de diélectrique.

Par contre, dans la partie de mémoire non-volatile, des hautes tensions sont en jeu et peuvent engendrer des effets parasites, et il serait souhaitable à cet égard d'améliorer l'isolation latérale.

En d'autres termes, il serait souhaitable de fabriquer des tranchées d'isolation latérales moins profondes dans la partie logique, et des tranchées d'isolation latérales plus profondes dans la partie de mémoire non volatile.

Bien entendu, le besoin de fabriquer des tranchées d'isolation latérales de différentes profondeurs n'est pas limité à l'exemple présenté ci-dessus d'une partie logique et d'une mémoire non volatile, et peut s'appliquer à d'autres parties et d'autres types de dispositif de circuit intégré.

En effet, selon un autre exemple, donné là-encore à titre non limitatif, une phase de formation de tranchées dans le substrat semiconducteur d'un circuit intégré peut également être prévue pour la fabrication des grilles verticales de transistors enterrés à grilles verticales, ou pour la fabrication d'éléments capacitifs verticaux dans le substrat.

De même, les tranchées destinées à accueillir des grilles verticales ou des électrodes d'éléments capacitifs sont formées simultanément, voire simultanément aussi avec la formation des tranchées d'isolation latérales.

Et, la profondeur des tranchées accueillant des grilles verticales influe sur les performances des transistors enterrés et sur les autres étapes de fabrication des transistors enterrés, une profondeur établie est donc très délicate à modifier. Par contre, il serait avantageux pour les éléments capacitifs verticaux de bénéficier de tranchées plus profondes, afin d'augmenter la valeur capacitive surfacique desdits éléments capacitifs.

En d'autres termes, il serait également souhaitable de fabriquer des tranchées d'isolation latérales plus profondes pour les électrodes d'éléments capacitifs verticaux que les tranchées pour les grilles verticales de transistors enterrés ou les tranchées d'isolation latérales.

Dissocier les fabrications de tranchées dans le substrat semiconducteur dans les différentes parties du substrat, en fonction de l'usage de la tranchée, n'est pas envisagé dans les productions industrielles pour des raisons de coût (sauf éventuellement exceptionnellement pour des besoins très spécifiques).

Des techniques classiques proposent de retirer une partie du diélectrique remplissant les tranchées d'isolation latérales afin de réduire le volume de diélectrique et ainsi de relâcher des contraintes liées au volume de diélectrique. Ces techniques présentent l'inconvénient d'introduire des effets parasites, du type « hump » selon le terme usuel anglais (c'est-à-dire notamment des déformations des caractéristiques des transistors), généralement à cause d'effets de bords causés par le retrait d'une partie du diélectrique.

Il serait souhaitable de bénéficier de tranchées de différentes profondeurs dans le substrat à moindre coût, et sans effet parasite.

Selon un aspect il est proposé un procédé de fabrication de circuit intégré comportant un substrat semiconducteur ayant une première zone et une deuxième zone, le procédé comprenant une phase de formation de tranchées dans le substrat. La phase de formation de tranchées comprend :
- une formation d'une première couche d'arrêt sur une face avant du substrat, dans la première zone et dans la deuxième zone ;
- une formation d'une deuxième couche d'arrêt sur la première couche d'arrêt dans la deuxième zone ; et
- une gravure sèche délimitée par un masque de gravure dans la première zone et dans la deuxième zone, configurée pour graver en un temps donné dans la première zone, la première couche d'arrêt puis au moins une première tranchée dans le substrat jusqu'à une première profondeur par rapport à la face avant, et pour graver en même temps dans la deuxième zone, la deuxième couche d'arrêt, puis la première couche d'arrêt, puis au moins une deuxième tranchée dans le substrat jusqu'à une deuxième profondeur par rapport à la face avant, la deuxième profondeur étant inférieure à la première profondeur.

En d'autres termes, une seule étape de gravure sèche permet de former des tranchées de profondeurs différentes dans la première zone et dans la deuxième zone. La différence entre les profondeurs est obtenue par le temps consacré à la gravure de la deuxième couche d'arrêt dans la deuxième zone qui n'est pas consacré à la gravure de la tranchée dans le substrat dans la durée totale du temps donné de la gravure sèche. En outre, la formation de la deuxième couche d'arrêt n'est pas critique en matière d'alignement, ni des matériaux utilisés, et le coût de son utilisation est modéré.

Avantageusement, le procédé comprend en outre un retrait de la deuxième couche d'arrêt en entier.

Selon un mode de mise en œuvre, le procédé comprend en outre, après la gravure sèche, une gravure humide configurée pour retirer latéralement une portion de la première couche d'arrêt sur les flancs gravés par la gravure sèche, dans lequel la deuxième couche d'arrêt est configurée pour que ladite gravure humide produise ledit retrait de la deuxième couche d'arrêt en entier.

En d'autres termes, il est proposé d'utiliser une gravure humide déjà prévue dans un procédé de gravure pour retirer une portion latérale de la première couche d'arrêt, usuellement dite « nitride pull back », afin de retirer complètement la deuxième couche d'arrêt. La deuxième couche est avantageusement configurée pour réagir de façon appropriée à la gravure humide telle qu'elle est initialement prévue, c'est-à-dire pour être complètement retirée.

Selon un mode de mise en œuvre, la première couche d'arrêt et la deuxième couche d'arrêt comprennent du nitrure de silicium, et la deuxième couche d'arrêt comprend des dopants à une concentration choisie pour que ladite gravure humide produise ledit retrait de la deuxième couche d'arrêt en entier.

Selon un autre mode de mise en œuvre, la première couche d'arrêt comprend du nitrure de silicium, et la deuxième couche d'arrêt comprend un matériau, différent du nitrure de silicium de la première couche d'arrêt, configuré pour que ladite gravure humide produise ledit retrait de la deuxième couche d'arrêt en entier.

En d'autres termes, la deuxième couche d'arrêt est avantageusement choisie vis-à-vis de la gravure sèche pour introduire un certain différentiel de profondeur des tranchées de la première zone et de la deuxième zone, et aussi vis-à-vis de la gravure humide pour être entièrement retirée lors de l'étape de retrait d'une portion latérale sur les flancs de la première couche d'arrêt (étape de « nitride pull back »). Doper du nitrure de silicium permet de paramétrer la réactivité de la deuxième couche d'arrêt avec la gravure humide, et ainsi de paramétrer l'épaisseur de cette couche et donc aussi la différence entre les profondeurs.

Selon un mode de mise en œuvre, le procédé comprend un remplissage à l'excès des tranchées par un matériau diélectrique, et un polissage mécano-chimique arrêté par la première couche d'arrêt, les tranchées ainsi remplies étant destinées à former des tranchées d'isolation latérale.

Le procédé peut avantageusement comprendre un retrait de la deuxième couche d'arrêt en entier afin de simplifier la détection de la première couche d'arrêt pour arrêter le polissage mécano-chimique.

Ce dernier mode de mise en œuvre est bien adapté, mais pas indispensable, lorsque le procédé comprend en outre des étapes de formation d'une mémoire non-volatile dans la première zone du substrat, et des étapes de formation d'une partie logique dans la deuxième zone du substrat.

Selon un autre mode de mise en œuvre, le procédé comprend une formation d'une enveloppe diélectrique sur les flancs et le fond des tranchées, un remplissage à l'excès des tranchées par un matériau conducteur, et un polissage mécano-chimique arrêté par la première couche d'arrêt, les tranchées ainsi remplies dans la première zone étant destinées à former des électrodes verticales d'éléments capacitifs, les tranchées ainsi remplies dans la deuxième zone étant destinées à former des grilles verticales de transistors enterrés.

De même, le procédé peut avantageusement comprendre un retrait de la deuxième couche d'arrêt en entier afin de simplifier la détection de la première couche d'arrêt du polissage mécano-chimique.

Ce dernier mode de mise en œuvre est bien adapté, mais pas indispensable, lorsque le procédé comprend en outre des étapes de formation d'un élément capacitif dans la première zone du substrat, et des étapes de formation d'une mémoire non-volatile dans la deuxième zone du substrat.

Par exemple, la différence entre la première profondeur et la deuxième profondeur est comprise entre 10nm et 100nm.

Selon un autre aspect, il est proposé un circuit intégré, comportant un substrat semiconducteur ayant une face avant, une première zone du substrat comportant au moins un premier élément formé dans une première tranchée s'étendant verticalement dans le substrat à une première profondeur par rapport à la face avant, et une deuxième zone du substrat comportant au moins un deuxième élément formé dans une deuxième tranchée s'étendant verticalement dans le substrat à une deuxième profondeur par rapport à la face avant, la deuxième profondeur étant inférieure à la première profondeur.

Bien entendu, « verticalement » signifie dans ce contexte « dans une direction perpendiculaire à la face avant ».

Selon un mode de réalisation, le procédé comporte une tranchée de transition délimitant la première zone d'un côté de la tranchée de transition et la deuxième zone de l'autre côté de la tranchée de transition, le fond de la tranchée de transition étant asymétrique par rapport à un plan médian de la tranchée de transition et situé entre ledit côté et ledit autre côté.

En d'autres termes, le fond de la tranchée de transition comporte une partie basse, du côté de la première zone, et une partie haute, moins profonde que la partie basse, du côté de la deuxième zone. Un plan incliné relie la partie basse et la partie haute dans le fond de la tranchée de transition.

Selon un mode de réalisation, ledit au moins un premier élément comprend une tranchée d'isolation latérale et ledit au moins un deuxième élément comprend une tranchée d'isolation latérale.

Ce dernier mode de réalisation est bien adapté, mais pas indispensable, lorsque la première zone comporte une mémoire non-volatile, et la deuxième zone comporte une partie logique.

En effet, la mémoire non volatile bénéficie ainsi d'une meilleure isolation latérale réduisant les effets parasites de fuites, et la partie logique bénéficie de moindres contraintes mécaniques réduisant les risques de dislocation.

Selon un autre mode de réalisation, ledit au moins un premier élément comprend une grille verticale d'un transistor enterré, et ledit au moins un deuxième élément comprend une électrode verticale d'un élément capacitif.

Ce dernier mode de réalisation est bien adapté, mais pas indispensable, lorsque la première zone comporte un élément capacitif, et la deuxième zone comporte une mémoire non-volatile.

En effet, l'électrode verticale peut ainsi couvrir une surface plus importante en profondeur dans le substrat, et la valeur capacitive surfacique de l'élément capacitif peut ainsi être augmentée, sans être limitée par une profondeur établie des tranchées des transistors enterrés.

D'autres avantages et caractéristiques de l'invention apparaîtront à l'examen de la description détaillée de modes de réalisation et de mise en œuvre, nullement limitatifs, et des dessins annexés sur lesquels :
[Fig 1]
[Fig 2]
[Fig 3]
[Fig 4]
[Fig 5]
[Fig 6]
[Fig 7]
[Fig 8]
[Fig 9]
[Fig 10]
[Fig 11]

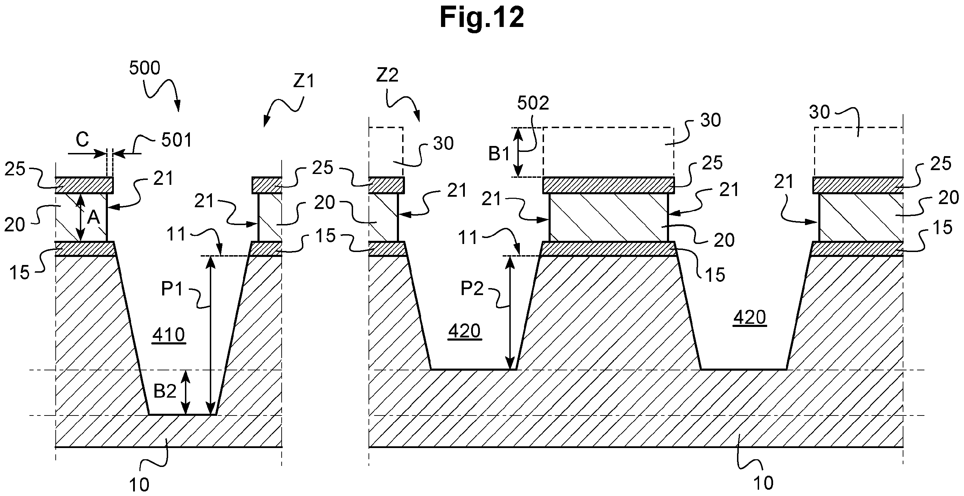

[Fig 12] illustrent des résultats d'étapes de modes de mise en œuvre de l'invention.

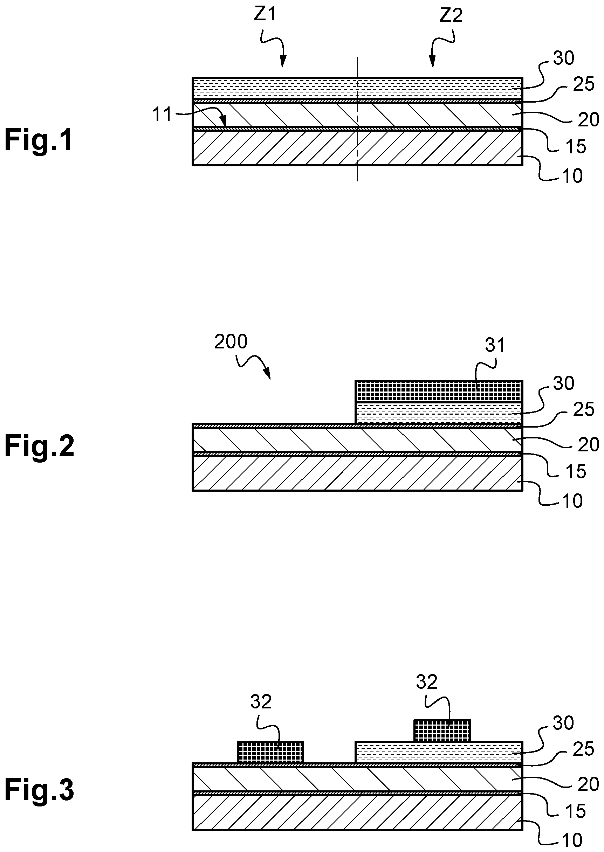

La figure 1 illustre le résultat d'une étape d'une phase de formation de tranchées dans un substrat semiconducteur 10, dans un procédé de fabrication de circuit intégré.

Le substrat semiconducteur 10 est par exemple formé en silicium et comprend une première zone Z1 et une deuxième zone Z2.

Selon une première variante, la première zone Z1 peut être destinée à comporter une région de mémoire non-volatile et la deuxième zone Z2 peut être destinée à comporter une partie logique, par exemple toutes deux incorporées dans un microcontrôleur.

Selon une deuxième variante, la première zone Z1 peut être destinée à comporter un élément capacitif à structure verticale dans le substrat, et la deuxième zone Z2 peut être destinée à comporter une mémoire non volatile, par exemple tous deux incorporés dans un microcontrôleur.

L'élément capacitif peut avoir une structure verticale telle que par exemple décrite dans les demandes de brevet français n°1757907, n°1757906, ou encore n°1902278.

Le substrat 10 comporte une face avant 11, qui correspond à la face du substrat 10 à partir de laquelle vont être réalisés des composants électroniques, tels que des transistors ou des diodes, dans la partie autrement désignée « FEOL » pour « Front End Of Line » selon le vocable anglais usuel.

La face avant 11 a été recouverte d'une couche d'oxyde tampon 15 classique. Par exemple la couche d'oxyde tampon comporte environ 7nm de dioxyde de silicium obtenu par dépôt ou croissance.

Une première couche d'arrêt 20 a été formée sur la couche d'oxyde tampon 15 sur face avant 11 du substrat 10, dans la première zone Z1 et dans la deuxième zone Z2.

Par exemple, la première couche d'arrêt 20 est formée en nitrure de silicium, et est obtenue par dépôt chimique en phase vapeur à basse pression (« LPCVD »). La première couche d'arrêt 20 peut avoir une épaisseur d'environ 80 nm.

Une deuxième couche d'arrêt 30 a été formée sur la première couche d'arrêt 20, dans la première zone Z1 et dans la deuxième zone Z2.

Par exemple, la première couche d'arrêt 30 est formée en nitrure de silicium dopé, et est obtenue par dépôt chimique en phase vapeur sous environnement plasma (« PECVD »). Le dopage peut être effectué in-situ lors du dépôt ou ex-situ par une implantation subséquente. La deuxième couche d'arrêt 30 peut avoir une épaisseur d'environ 40 nm. On se référera à la description ci-après en relation avec la figure 12 pour évaluer l'épaisseur de la deuxième couche d'arrêt 30.

En alternative, la deuxième couche d'arrêt 30 peut être d'une autre nature et résulter d'autres techniques de formation, à condition de respecter par exemple les conditions décrites ci-après en relation avec la figure 12.

Une couche d'oxyde inter-nitrure 25 a été formée entre la première couche d'arrêt 20 et la deuxième couche d'arrêt 30, et peut comprendre une épaisseur d'environ 5nm de dioxyde de silicium.

La figure 2 représente le résultat d'une étape de retrait 200 de la deuxième couche d'arrêt 30 dans la première zone Z1, de façon à former la deuxième couche d'arrêt 30 dans la deuxième zone Z2 seulement.

Le retrait 200 comprend une formation d'un masque 31, dont l'alignement peut être grossier, et une gravure sélective pour graver la deuxième couche d'arrêt 30 mais ne pas réagir avec la couche d'oxyde inter-nitrure 25. Une telle gravure sélective est typiquement mise en œuvre par un bain d'acide phosphorique H₃PO₄.

La figure 3 représente la formation d'un masque de gravure 32 lithographié de façon à découvrir le dessin des futures tranchées sur les surfaces de la première couche d'arrêt 20 dans la première zone Z1 et de la deuxième couche d'arrêt 30 dans la deuxième zone Z2.

La figure 4 représente le résultat d'une gravure sèche 400 délimitée par le masque de gravure 32.

La gravure sèche 400, par exemple du type à bombardement d'ions, est capable de graver la deuxième couche d'arrêt, la couche d'oxyde inter-nitrures 25, la première couche d'arrêt 20, la couche d'oxyde tampon 15 et le silicium du substrat 10.

La gravure sèche 400 est appliquée sur la structure décrite ci-dessus en relation avec la figure 3 pendant un temps donné, de façon à former des tranchées 410, 415, 420 dans le substrat 10, dans la première zone Z1 et dans deuxième zone Z2.

Ainsi, dans la première zone Z1, la couche d'arrêt 20 est d'abord gravée dans les parties qui ne sont pas recouvertes par le masque 32. Puis, au moins une première tranchée 410 est gravée dans le substrat 10 jusqu'à une première profondeur P1, par rapport à la face avant 11.

Pendant le même temps, dans la deuxième zone Z2, l'empilement de la deuxième couche d'arrêt 30 et de la première couche d'arrêt 20, non recouvert par le masque 32, est gravé. Puis, au moins une deuxième tranchée 420 est gravée dans le substrat 10 pendant le temps restant dudit temps donné de gravure sèche 400. La deuxième tranchée 420 a ainsi une deuxième profondeur P2 par rapport à la face avant 11. En raison du temps utilisé pour retirer la deuxième couche d'arrêt 30, le substrat à été exposé à la gravure 400 moins longtemps, et la deuxième profondeur P2 est inférieure à la première profondeur P1.

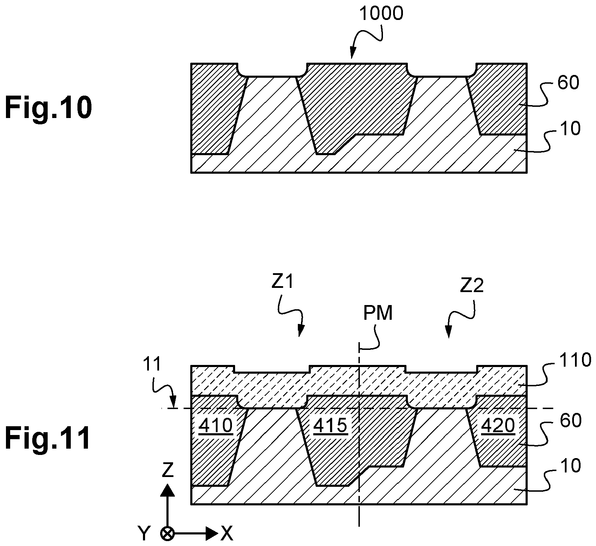

Dans cet exemple, une tranchée 415, dite de transition, a été formée au niveau de la transition entre la première zone Z1 et la deuxième zone Z2. Etant donné qu'au niveau de ladite transition, une partie (à droite sur la figure) de l'ouverture du masque de gravure 32 (figure 3) comporte l'empilement de la première couche d'arrêt 20 et de la deuxième couche d'arrêt 30, tandis que l'autre partie de l'ouverture (à gauche sur la figure) ne comporte que la première couche d'arrêt, le fond de la tranchée de transition va présenter une variation de profondeur. L'effet de la gravure sèche 400 sur le substrat va produire un plan incliné entre la partie basse et la partie haute du fond de la tranchée de transition, présentant de ce fait une asymétrie par rapport à un plan médian de la tranchée. La description de cette asymétrie sera reprise ci-après en relation avec la figure 11.

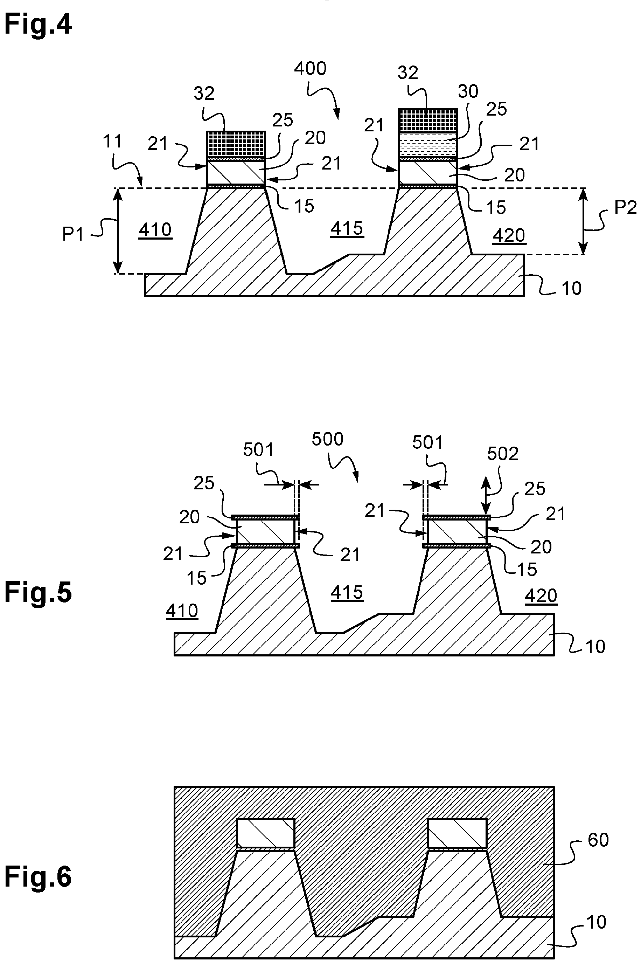

La figure 5 représente le résultat d'une gravure humide 500, destinée à la fois à retirer latéralement une portion 501 des reliquats de la première couche d'arrêt 20, et à retirer complètement 502 la deuxième couche d'arrêt 30.

La gravure humide peut être mise en œuvre par un bain d'acide phosphorique H₃PO₄, par exemple typiquement prévu pour le retrait des portion latérales 501 de la première couche d'arrêt en nitrure de silicium. Cette étape est usuellement désignée par le terme anglais « Nitride Pull Back ».

On se réfère à la figure 12.

La figure 12 représente la structure obtenue dans le procédé de formation des tranchées au même moment que la figure 5, après la gravure humide 500. Les mêmes éléments supportent les mêmes références et ne sont pas tous à nouveau détaillés ici.

Comme mentionné précédemment en relation avec la figure 5, la gravure humide 500 est du type bain d'acide phosphorique H₃PO₄ et est donc sélective pour dissoudre le nitrure de silicium et ne pas réagir (ou pour le moins réagir de façon négligeable) avec l'oxyde de silicium SiO₂ et le silicium du substrat 10.

La première couche d'arrêt 20, en nitrure de silicium, présente une vitesse de gravure, ou réactivité, par l'acide phosphorique donnée, de valeur ER20 par exemple de l'ordre de 8nm/min.

La gravure humide 500 est configurée pour retirer une largeur C latéralement sur les flancs 21 de la première couche d'arrêt 20, dans le trou formé dans la première couche d'arrêt 20 par la gravure sèche 400.

La deuxième couche d'arrêt 30, en nitrure de silicium dopé ou en un autre matériau, est configurée pour présenter une vitesse de gravure, ou réactivité, par l'acide phosphorique de valeur ER30, par exemple de l'ordre de 40nm/min.

On considère que la gravure sèche 400 est configurée pour graver à la même vitesse la deuxième couche d'arrêt 20, la première couche d'arrêt 30 et le silicium du substrat 10, de sorte que la différence B2 entre la première profondeur P1 et la deuxième profondeur P2 est égale à l'épaisseur B1 de la deuxième couche d'arrêt 30. Bien entendu, en pratique, les couches susmentionnées peuvent être gravées par la gravure sèche 400 à des vitesses légèrement différentes entre elles. Ainsi, la différence de profondeur B2 entre les profondeurs P1 et P2 qui en résulte peut être différente de l'épaisseur B1 de la deuxième couche d'arrêt 30. En tout état de cause, l'homme du métier pourra calculer le différentiel de profondeur obtenu avec la connaissance des vitesses de gravure des matériaux choisis par la gravure sèche 400 utilisée en pratique.

En résumé, la gravure humide 500 est prévue et configurée pour retirer une portion latérale 501 sur les flancs 21 des reliquats de la première couche d'arrêt 20.

La deuxième couche d'arrêt 30 est configurée pour que ladite gravure humide 500 produise un retrait total, en entier, de la deuxième couche d'arrêt 30. Par exemple le choix de la concentration de dopants dans du nitrure de silicium, ou le choix d'un autre matériau peut permettre de configurer la deuxième couche d'arrêt à cet égard.

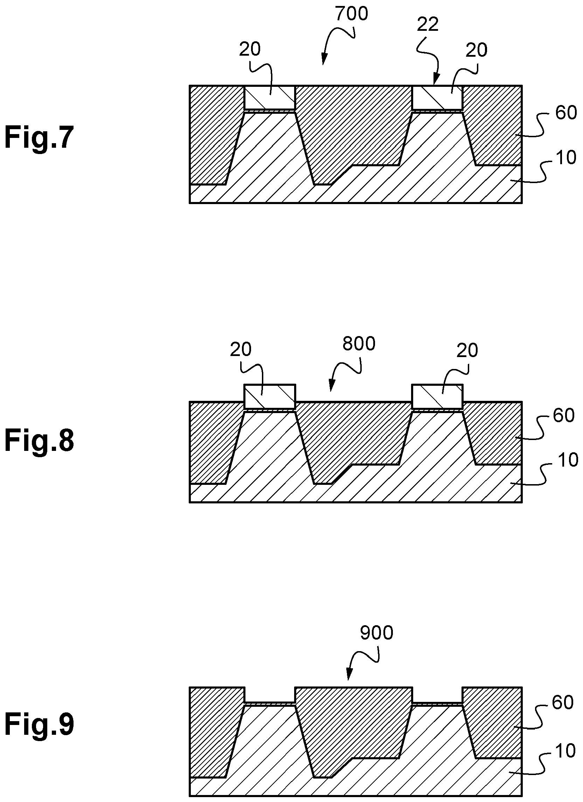

En effet, comme il apparaîtra dans la suite en relation avec la figure 7, la première couche 20 d'arrêt doit être découverte pour l'étape de polissage 700.

Ainsi, pour des raisons de coûts, il est préférable de concevoir la deuxième couche d'arrêt 30 vis-à-vis de sa réactivité avec la gravure humide 500, plutôt que de prévoir une gravure supplémentaire pour retirer ou finir de retirer la deuxième couche d'arrêt 30.

L'épaisseur maximale B1 de la deuxième couche d'arrêt est donc paramétrée par la réactivité ER30 du matériau de la deuxième couche d'arrêt 30 avec l'acide phosphorique 500.

Enfin, cette épaisseur B1 produit le différentiel de profondeur B2 entre les premières tranchées 410 situées dans la première zone du substrat 10 et les deuxième tranchées 420 situées dans la deuxième zone du substrat 10.

Par exemple, en pratique, si la gravure humide « nitride pull back » est limitée (par une technologie donnée) à un retrait latéral de 30nm d'épaisseur dans la première couche d'arrêt 20, alors, avec k=ER30/ER20, l'épaisseur B1 de la deuxième couche d'arrêt 30 est limitée à k^{∗}30nm. L'épaisseur B1=k^{∗}30nm introduit un différentiel profondeur B2 en fonction de la gravure sèche 400, par exemple B2=B1. Par conséquent, en choisissant par exemple le dopage du nitrure de silicium de la deuxième couche d'arrêt 30 pour paramétrer rapport k, on peut paramétrer la valeur de la différence de profondeur B2 entre les premières tranchées 410 et les deuxièmes tranchées 420.

La nature et la concentration de dopants implantés dans le nitrure de silicium peuvent permettre de faire varier le rapport k de 2 à 20.

La figure 6 représente le résultat d'une étape de remplissage à l'excès des tranchées 410, 415, 420 par un matériau de tranchée 60.

Par exemple dans la première variante mentionnée ci-avant en relation avec la figure 1, le matériau de tranchée 60 peut être un diélectrique, par exemple du dioxyde de silicium, afin de former des tranchées d'isolation latérales, du type « STI », acronyme du terme anglais usuel « Shallow Trench Isolation ».

Par exemple dans la deuxième variante mentionnée ci-avant en relation avec la figure 1, le matériau de tranchée 60 peut être, en alternative, un matériau conducteur, tel que du silicium polycristallin, afin de former des électrodes verticales d'éléments capacitifs dans la première zone Z1 et des grilles verticales de transistors enterrés dans la deuxième zone Z2.

La figure 7 illustre le résultat d'une étape de polissage mécano-chimique 700 du matériau de tranchée, arrêté lorsque la surface 22 de première couche d'arrêt 20 est atteinte.

La figure 8 représente le résultat d'une étape 800 de renfoncement du matériau de grille 60 typique, par exemple par bain d'oxyde fluorhydrique si le matériau de grille 60 est en dioxyde de silicium, ou par une gravure sèche si le matériau de grille 60 est en silicium polycristallin.

La figure 9 représente le résultat d'une étape 900 de retrait de la première couche d'arrêt 20 typique, par gravure humide sélective telle qu'un bain d'acide phosphorique H₃PO₄.

La figure 10 représente le résultat d'une gravure humide 1000 typique, notamment afin de retirer la couche d'oxyde tampon 15 de face avant 11 du substrat 10.

La figure 11 représente schématiquement le résultat d'une formation d'une structure 110 sur la face avant 11 ainsi découverte du substrat 10. La structure peut par exemple comprendre des transistors ayant des grilles, par exemple reliées entre elles par un barreau de silicium polycristallin 110.

On remarquera sur la structure de la figure 11 obtenue à l'issue du procédé décrit ci-dessus en relation avec les figures 1 à 11, qu'une tranchée 415, dite de transition, a été formée entre la première zone Z1 et la deuxième zone Z2.

La tranchée de transition 415 s'étend en longueur dans la direction Y et délimite en largeur la première zone Z1 d'un côté de la tranchée de transition 415 dans la direction X et la deuxième zone Z2 de l'autre côté dans la direction X.

Le procédé ayant permis d'obtenir la structure a généré, dans le fond de la tranchée de transition 415, une asymétrie par rapport à un plan médian PM dans les directions Y et Z, et au milieu de la largeur (X) de la tranchée de transition 415. En d'autres termes, le plan médian de la tranchée de transition 415 est situé entre ledit côté (Z1) et ledit autre côté (Z2).

Avec X, Y, Z les trois directions orthogonales de l'espace telles que la face avant 11 du substrat 10 appartient à un plan dans les directions X et Y.

Un circuit intégré peut avantageusement comporter la structure de la figure 11, et comprendre, dans la première zone Z1, au moins un premier élément formé dans une première tranchée 410 s'étendant dans le substrat 10 dans une direction perpendiculaire à la face avant 11, à une première profondeur P1 par rapport à la face avant 11, et, dans la deuxième zone Z2, au moins un deuxième élément formé dans une deuxième tranchée 420 s'étendant dans le substrat 10 dans une direction perpendiculaire à la face avant 11, à une deuxième profondeur P2 par rapport à la face avant 11, la deuxième profondeur P2 étant inférieure à la première profondeur P1.

Le circuit intégré peut ainsi comprendre une mémoire non volatile ayant des bonnes isolations latérales afin de réduire par exemple des effets parasites de fuites, ainsi qu'une partie logique ne subissant pas ou peu de contraintes mécaniques par les tranchées d'isolation latérale.

Le circuit intégré peut aussi comprendre une structure capacitive verticale dans le substrat, à haute valeur capacitive par unité de surface, et en parallèle par exemple des transistors enterrés à grilles verticales de caractéristiques indépendantes de la profondeur de la structure capacitive.

Bien entendu l'invention n'est pas limitée à ces modes de réalisation mais en embrasse toutes les variantes, et peut s'appliquer à d'autres parties de circuit intégré et d'autres types de dispositif de circuit intégré que la partie logique, la mémoire non volatile ou l'élément capacitif mentionnés précédemment.

## Revendications

1. Procédé de fabrication de circuit intégré comportant un substrat semiconducteur (10) ayant une première zone (Z1) et une deuxième zone (Z2), le procédé comprenant une phase de formation de tranchées (410, 415, 420) dans le substrat (10), la phase de formation de tranchées comprenant :
- une formation d'une première couche d'arrêt (20) sur une face avant (11) du substrat (10), dans la première zone (Z1) et dans la deuxième zone (Z2) ;
- une formation d'une deuxième couche d'arrêt (30) sur la première couche d'arrêt (20) dans la deuxième zone (Z2) ; et
- une gravure sèche (400) délimitée par un masque de gravure (32) dans la première zone (Z1) et dans la deuxième zone (Z2), configurée pour graver en un temps donné dans la première zone (Z1), la première couche d'arrêt (20) puis au moins une première tranchée (410) dans le substrat (10) jusqu'à une première profondeur (P1) par rapport à la face avant (11), et pour graver en même temps dans la deuxième zone (Z2), la deuxième couche d'arrêt (30), puis la première couche d'arrêt (20), puis au moins une deuxième tranchée (420) dans le substrat (10) jusqu'à une deuxième profondeur (P2) par rapport à la face avant (11), la deuxième profondeur (P2) étant inférieure à la première profondeur (P1).

2. Procédé selon la revendication 1, comprenant en outre un retrait (500) de la deuxième couche d'arrêt en entier (30).

3. Procédé selon la revendication 2, comprenant, après la gravure sèche (400), une gravure humide (500) configurée pour retirer latéralement une portion (501) de la première couche d'arrêt (20) sur les flancs (21) gravés par la gravure sèche (400), dans lequel la deuxième couche d'arrêt (30) est configurée pour que ladite gravure humide (500) produise ledit retrait de la deuxième couche d'arrêt en entier (30).

4. Procédé selon la revendication 3, dans lequel la première couche d'arrêt (20) et la deuxième couche d'arrêt (30) comprennent du nitrure de silicium, la deuxième couche d'arrêt (30) comprend des dopants à une concentration choisie pour que ladite gravure humide (500) produise ledit retrait de la deuxième couche d'arrêt en entier (30).

5. Procédé selon la revendication 3, dans lequel la première couche d'arrêt (20) comprend du nitrure de silicium, et la deuxième couche d'arrêt (30) comprend un matériau, différent du nitrure de silicium de la première couche d'arrêt (20), configuré pour que ladite gravure humide (500) produise ledit retrait de la deuxième couche d'arrêt en entier (30).

6. Procédé selon l'une des revendications précédentes, comprenant un remplissage à l'excès des tranchées (410, 415, 420) par un matériau diélectrique (60), et un polissage mécano-chimique (700) arrêté par la première couche d'arrêt (20), les tranchées ainsi remplies (410, 420) étant destinées à former des tranchées d'isolation latérale.

7. Procédé selon l'une des revendications précédentes, comprenant en outre des étapes de formation d'une mémoire non-volatile dans la première zone (Z1) du substrat (10), et des étapes de formation d'une partie logique dans la deuxième zone (Z2) du substrat (10).

8. Procédé selon l'une des revendications 1 à 5, comprenant une formation d'une enveloppe diélectrique sur les flancs et le fond des tranchées (410, 420), un remplissage à l'excès des tranchées (410, 420) par un matériau conducteur (60), et un polissage mécano-chimique (700) arrêté par la première couche d'arrêt (20), les tranchées ainsi remplies (410, 420) dans la première zone (Z1) étant destinées à former des électrodes verticales d'éléments capacitifs, les tranchées ainsi remplies (420) dans la deuxième zone (Z2) étant destinées à former des grilles verticales de transistors enterrés.

9. Procédé selon l'une des revendications 1 à 5 ou selon la revendication 8, comprenant en outre des étapes de formation d'un élément capacitif dans la première zone (Z1) du substrat (10), et des étapes de formation d'une mémoire non-volatile dans la deuxième zone (Z2) du substrat (10).

10. Procédé selon l'une des revendications précédentes, dans lequel la différence entre la première profondeur (P1) et la deuxième profondeur (P2) est comprise entre 10nm et 100nm.

11. Circuit intégré, comportant un substrat semiconducteur (10) ayant une face avant (11), une première zone (Z1) du substrat (10) comportant au moins un premier élément formé dans une première tranchée (410) s'étendant verticalement dans le substrat à une première profondeur (P1) par rapport à la face avant (11), et une deuxième zone (Z2) du substrat (10) comportant au moins un deuxième élément formé dans une deuxième tranchée (420) s'étendant verticalement dans le substrat à une deuxième profondeur (P2) par rapport à la face avant (11), la deuxième profondeur (P2) étant inférieure à la première profondeur (P1).

12. Circuit intégré selon la revendication 11, comportant une tranchée de transition (415) délimitant la première zone (Z1) d'un côté de la tranchée de transition (415) et la deuxième zone (Z2) de l'autre côté de la tranchée de transition (415), le fond de la tranchée de transition (415) étant asymétrique par rapport à un plan médian (PM) de la tranchée de transition (415) et situé entre ledit côté et ledit autre côté.

13. Circuit intégré selon l'une des revendications 11 ou 12, dans lequel ledit au moins un premier élément comprend une tranchée d'isolation latérale et ledit au moins un deuxième élément comprend une tranchée d'isolation latérale.

14. Circuit intégré selon l'une des revendications 11 à 13, dans lequel la première zone (Z1) comporte une mémoire non-volatile, et la deuxième zone (Z2) comporte une partie logique.

15. Circuit intégré selon l'une des revendications 11 ou 12, dans lequel ledit au moins un premier élément comprend une grille verticale d'un transistor enterré, et ledit au moins un deuxième élément comprend une électrode verticale d'un élément capacitif.

16. Circuit intégré selon l'une des revendications 11, 12 ou 15, dans lequel la première zone (Z1) comporte un élément capacitif, et la deuxième zone (Z2) comporte une mémoire non-volatile.
